Europäisches Patentamt

European Patent Office

Office européen des brevets

(19)

(11) Veröffentlichungsnummer: **0 199 979 B1**

(12) **EUROPÄISCHE PATENTSCHRIFT**

(45) Veröffentlichungstag der Patentschrift: **17.07.91**

(51) Int. Cl.⁵: **G01R 27/08, G01R 27/16**

(21) Anmeldenummer: **86103898.2**

(22) Anmeldetag: **21.03.86**

(54) Messverfahren zur Bestimmung des Schleifen- oder Innenwiderstandes eines Wechselstromnetzes und Vorrichtung zur Anwendung des Verfahrens.

(30) Priorität: **13.04.85 DE 3513247**

(43) Veröffentlichungstag der Anmeldung:
**10.12.86 Patentblatt 86/45**

(45) Bekanntmachung des Hinweises auf die Patenterteilung:
**17.07.91 Patentblatt 91/29**

(84) Benannte Vertragsstaaten:
**DE FR GB IT NL SE**

(56) Entgegenhaltungen:
**EP-A- 0 117 132**
**EP-A- 0 165 512**
**DE-A- 2 449 016**

**ETZ, Band 102, Nr. 14, 102. Jahrgang 1981, Seiten 762-764, Berlin und Offenbach; P. DÄNZER: "Schleifwiderstand und Kurzschlussstrom gemessen mit Schleifwiderstands-Messgeräten"**

(73) Patentinhaber: **Asea Brown Boveri Aktiengesellschaft**
**Kallstadter Strasse 1**
**W-6800 Mannheim-Käfertal(DE)**

(72) Erfinder: **Schick, Herbert**
**Albrechtstrasse 7**
**W-8510 Fürth(DE)**

(74) Vertreter: **Rupprecht, Klaus, Dipl.-Ing. et al**
**c/o Asea Brown Boveri Aktiengesellschaft**
**Zentralbereich Patente Postfach 100351**
**W-6800 Mannheim 1(DE)**

## Beschreibung

Die Erfindung betrifft ein im Oberbegriff des Anspruchs 1 genanntes Verfahren und eine zur Anwendung dieses Verfahrens geeignete Vorrichtung gemäß Oberbegriff des Anspruchs 7.

Zur Messung des Innen- und Scheinwiderstandes bei Wechselspannungsnetzen verwendet man bevorzugt das Verfahren der Spannungsabsenkung. Dabei wird das Netz einer sich ändernden Last ausgesetzt und in beiden Lastzuständen die Netzwechselspannung und der Laststrom gemessen. Die Differenz der beiden gemessenen Wechselspannungen durch die Differenz der beiden gemessenen Lastströme geteilt, ergibt den gesuchten Widerstandswert. Das Meßverfahren vereinfacht sich, wenn für den ersten Lastzustand der Leerlauf verwendet wird, weil dann nur ein Laststrom gemessen werden muß, der der Differenz zwischen Leerlauf und Last entspricht.

Sowohl die Differenzbildung der Meßwerte als auch die anschließende Division kann durch den Messenden selbst, aber auch durch einen geeigneten Rechner automatisch durchgeführt werden.

Aus etz, Band 102 (1981), Heft 14, Seite 762 bis 764 ist ein Meßgerät mit einem A/D-Wandler zur Meßwertanzeige bekannt, das eine automatische Berechnung des Schliefenwiderstandes ermöglicht und die im jeweiligen Oberbegriff der Ansprüche 1 und 7 aufgeführten, die Messung des Schliefenwiderstandes betreffenden Merkmale aufweist. Zunächst wird im Leerlauf eine Halbwelle der ersten Wechselspannung integriert und somit ein erster Mittelwert U1 gebildet und dann bei Last eine Halbwelle der zweiten Wechselspannung integriert und somit ein zweiter Mittelwert U2 gebildet. Ein Rechner sorgt für eine betragsmäßige Differenzbildung oder vektorielle Addition beider Spannungen und ermittelt so $_\Delta$ U. Eine anschließende Division durch den Laststrom ergibt den gesuchten Widerstand. Durch die Integration der Strom- und Spannungswerte wirken sich durch Störimpulse verursachte Fehler praktisch nicht aus. Das Gerät ist somit relativ komfortabel, benötigt hierzu aber einen teuren Rechner.

In der europäischen Patentanmeldung EP-A-0165512 (relevant gemäß Artikel 54(3) EPÜ) ist ein Verfahren zur Ermittlung der Differenz zwischen zwei Wechselspannungen beschrieben. Ein zeitgesteuerter Meßablauf sorgt dafür, daß in aufeinanderfolgenden, fest vorgegebenen Zeitspannen zuerst die eine und dann die andere Wechselspannung integriert wird. Die beiden gleichgerichteten Spannungen werden mit entgegengesetzter Polarität demselben Integrator zugeführt, der dann zuerst die eine der beiden Spannungen aufintegriert und anschließend mit der anderen abintegriert. Die sich nach Abschluß eines Integrationszyklus am Ausgang des Integrators einstellende Spannung entspricht dem Mittelwert der Differenz der beiden gemessenen Spannungen. Zur Differenzbildung wird somit nach diesem Verfahren kein Rechner benötigt. Die Differenzbildung kann allerdings auch auf andere Weise, z.B. über einen Differenzverstärker ohne zusätzlichen Rechner realisiert werden. Eine solche Schaltung würde aber einen größeren Fehler verursachen.

Das prioritätsältere Verfahren ist auch in seiner Anwendung zur Innenwiderstandsmessung bei Wechselstromnetzen beschrieben. Außer der Differenzspannung muß dann noch der Laststrom gemessen werden. Verwendet man als Laststrom einen eingeprägten Konstantstrom, so kann die Strommessung entfallen und der Innenwiderstand des Netzes ist der Differenzspannung proportional. Eigene Rechengänge und die Erzeugung eines als Laststrom wirkenden eingeprägten Konstantstromes erfordern aber einen erheblichen Aufwand.

Zur Messung von Widerständen mit Gleichstrom ist es weiterhin bekannt, bei Digitalvoltmetern den A/D-Wandler zur Quotientenbildung heranzuziehen. So ist in "messen und prüfen", Juli 1971, Seite 272 bis 276 ein digitales Multimeter beschrieben, das auch zur Widerstandsmessung geeignet ist. Der unbekannte Widerstand liegt in Reihe mit einem Meßwiderstand an einer Gleichspannungsquelle. Die am Meßwiderstand abfallende Spannung ist dem Strom proportional. Von dieser Spannung und der Spannung am unbekannten Widerstand wird am A/D-Wandler das Verhältnis gebildet. Ein Vorteil dieser Schaltung ist, daß sich eine lineare Abhängigkeit der Spannungen vom Wert des unbekannten Widerstandes ergibt. Die Veröffentlichung läßt jedoch nichts erkennen, was die Verwendung des beschriebenen Prinzips zur Innenwiderstandsmessung an Wechselspannungsnetzen nahelegen könnte.

Aufgabe der Erfindung ist es, ausgehend von einem Verfahren und einer Vorrichtung der eingangs genannten Art ein Verfahren und eine Vorrichtung zur Bestimmung des Netzinnenwiderstandes oder Schleifenwiderstandes zu entwickeln, die einen automatischen Meßablauf nach dem Spannungsabsenkungsverfahren ermöglichen und bei denen man über die sich ergebenden Meßwerte zum jeweiligen Widerstandswert gelangt, ohne daß ein eigener Rechenvorgang benötigt wird oder mit einem eingeprägten konstanten Laststrom gearbeitet werden muß.

Diese Aufgabe wird durch die in den Ansprüchen 1 und 7 gekennzeichneten Merkmale gelöst. Zweckmäßige Ausgestaltungen und Weiterbildungen des Erfindungsgegenstandes sind in den Unteransprüchen genannt.

Der entscheidende Vorteil der Erfindung besteht darin, daß die ohnehin erforderliche A/D-Wandlung gleichzeitig zur Verhältnisbildung herangezogen wird. Auf die Einprägung eines als Last wirkenden Konstantstroms kann verzichtet werden, da Änderungen der Netzspannung, wie sie insbesondere bei wechselnder Netzlast auftreten, bei der A/D-Wandlung kompensiert werden. Ebenso kann ein zusätzlicher Rechengang entfallen, wodurch sich der Meßablauf wesentlich vereinfacht.

In weiterer Ausbildung der Erfindung kann die Differenzbildung der Lastströme entfallen, wenn eine der beiden Messungen bei laufzeit erfolgt. Der Differenzstrom entspricht dann dem Strom, der in der Lastzeit fließt. Es ist weiterhin vorteilhaft, den Laststrom nicht unmittelbar im Laststromkreis zu messen, sondern durch einen bestimmten, in seiner Genauigkeit einem Meßwiderstand entsprechenden Lastwiderstand exakt vorzugeben. Der Laststrom kann sich dann nur in Abhängigkeit von der Netzspannung ändern. Wird nun eine der Netzspannung proportionale, entsprechend herabgeteilte Spannung während der Lastzeit zunächst gleichgerichtet und dann integriert als Referenzsignal bei der A/D-Wandlung verwendet, so werden Netzspannungsänderungen eliminiert, denn es gilt:

$$R_i = \frac{\Delta U \times R_L}{U_L}$$

Abweichungen der Netzspannung $U_L$ bei Last wirken sich im gleichen Verhältnis auf die Differenz $\Delta U$ aus, die sich aus Leerlaufspannung $U_0$ minus Lastspannung $U_L$ ergibt. Voraussetzung ist allerdings, daß die Spannungsänderungen nicht in den kurzen Zeitraum eines Meßzyklus fallen. Abweichungen vom Nennwert der Netzwechselspannung, die innerhalb eines Meßzyklus zwischen Leerlauf und Last auftreten, gehen in die Messung ein.

In einer Weiterbildung des Erfindungsgegenstandes ist deshalb vorgesehen, daß ein Meßzyklus zur Ausgabe des ermittelten Widerstandswertes mehrere Lastzeitwechsel erfaßt. Schon bei drei Lastzeitwechseln werden möglicherweise auftretende kurzzeitige Spannungsschwankungen durch Mittelwertbildung weitgehend unterdrückt.

Arbeitet man zur Ermittlung der Differenzspannung mit einem Verfahren der Auf/Ab-Integration, so fällt die Differenzspannung quasi automatisch ohne zusätzliche Maßnahmen, wie sie bei der Bildung von Absolutwerten notwendig sind, mit an. Außerdem verringert sich hierdurch auch der Meßfehler wesentlich. Nimmt man an, daß nach dem Verfahren der Auf/Ab-Integration bei der Ermittlung der Differenzspannung ein Fehler von 1 % entsteht, so kann dieser Fehler bei nachträglicher Differenzbildung getrennt integrierter Spannungen $U_1$, $U_2$ leicht 40 % und mehr erreichen.

Es ist zweckmäßig, wenn die Abintegration im gleichen Zeitpunkt (z.B. Nulldurchgang) beginnt, in dem die Aufintegration endet. Durch die unmittelbare Reihenfolge von Auf/Ab-Integrationen über jeweils eine Periode, ist die Gefahr, daß Netzspannungsschwankungen mitgemessen werden, geringer als bei Verfahren, bei denen Pausenzeiten zwischen der Erfassung beider Wechselspannungen auftreten.

Vorteilhaft ist weiterhin, das Verfahren der Auf/Ab-Integration so auszugestalten, daß die Differenzspannung über mehrere, eine Integrationsphase bildende Integrationszyklen ermittelt wird. Jeder Integrationszyklus umfaßt hierbei eine Auf- und eine Abintegration, und die am Integrator entstehende Summenspannung wird dann durch die Zahl der Integrationszyklen geteilt, um den Mittelwert der Differenzspannung zu erhalten. Durch diese Maßnahme werden zwei wesentliche Vorteile erzielt. So wird der Einfluß von Netzspannungsschwankungen erheblich reduziert, weil durch das mehrfache Auf- und Abintegrieren eine quasi statistische Mittelwertbildung des Meßwertes erfolgt. Weiterhin führt das Integrieren über mehrere Meßzyklen, besonders bei kleinen Differenzspannungen, einerseits zu höheren Spannungsabsolutwerten und andererseits durch die Mittelwertbildung zu einer verbesserten Meßgenauigkeit. Durch das unmittelbare Abintegrieren nach jeder Halbwelle bleiben die Ausgangsspannungen am Integrator relativ niedrig, so daß die nachgeschalteten Baugruppen keine große Aussteuerbarkeit besitzen müssen.

Eine Meßvorrichtung gemäß Anspruch 7 zur erfindungsgemäßen Anwendung des Meßverfahrens sieht vor, daß die am Netz anliegende Lastschaltung aus der Reihenschaltung eines bekannten Lastwiderstandes und eines Lastschalters besteht und zu dieser Reihenschaltung jeweils ein Spannungsteiler und weiterhin der Eingang einer Differenzspannungs-Meßschaltung parallelgeschaltet sind. Der Ausgang der Differenzspannungs-Meßschaltung ist mit dem Meßeingang und der Ausgang einer mit ihrem Eingang an den Spannungsteiler liegenden Integrationsschaltung ist mit dem Referenzeingang eines A/D-Wandler verbunden. Eine den Lastschalter, die Integrationsschaltung, deb A/D-Wandler und die Differenzspannungs-Meßschaltung steuernde Ablaufsteuerung bestimmt den Meßablauf.

Bei der Auswahl preisgünstiger Baugruppen wirkt sich der Umstand, daß sowohl die Meßspannung, wie auch die Referenzspannung dem A/D-Wandler über Kondensatoren zugeführt wird und ohnehin über einen Zeitraum von etwa 0,5 bis 1 Sekunde gleichbleibend anstehen muß, vorteilhaft aus, denn er ermöglicht die Verwendung eines relativ trägen A/D-Wandlers. Somit kann ein nach dem Dual-Slope-Verfahren arbeitender A/D-Wandler verwendet werden, den man als kostengünstige, auch den Anzeigeteil umfassende Baueinheit erwerben kann.

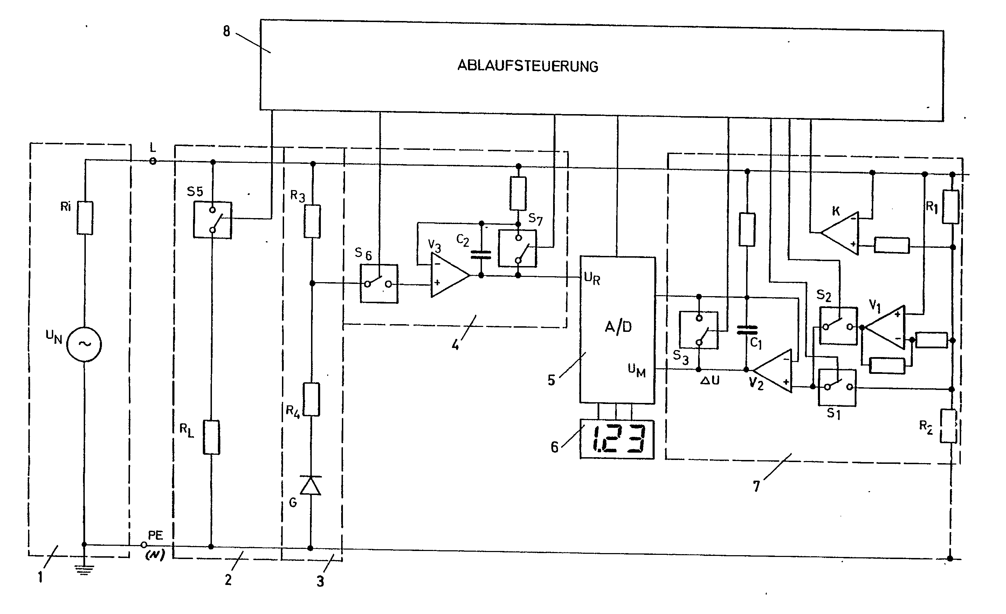

Ein Ausführungsbeispiel der Meßvorrichtung ist in der Zeichnung dargestellt und wird im folgenden näher beschrieben.

An einer Netzspannungsquelle 1 mit dem Innenwiderstand $R_i$ liegt eine Lastschaltung 2 mit dem Lastwiderstand $R_L$, zu dem ein Schalter S5 in Reihe geschaltet ist. Je nach dem, ob der Schleifenwiderstand oder der Innenwiderstand des Netzes ermittelt werden soll, wird die Lastschaltung zwischen L und N oder L und PE angeschlossen. Bei geöffnetem Schalter S5 liegt an den Klemmen der Netzspannungsquelle eine Leerlaufspannung $U_0$ und bei geschlossenem Schalter S5 eine Lastspannung $U_1$ an. Beide Spannungen $U_0$, $U_L$ werden einem Spannungsteiler 3 und einem Spannungsteiler $R_1$, $R_2$, der am Eingang einer Differenzspannungs-Meßschaltung 7 liegt, zugeführt. Die Differenzspannungs-Meßschaltung 7 sorgt dafür, daß am Meßeingang $U_M$ eines A/D-Wandlers 5 eine Differenzspannung $_\Delta U$ anliegt, die dem Mittelwert der Differenz von Leerlaufspannung $U_0$ und Lastspannung $U_L$ proportional ist.

Der Spannungsteiler 3 ist mit einem Einweggleichrichter G versehen, der jeweils eine Halbwelle der Wechselspannung unterdrückt. Über die Widerstände R3, R4 wird ein der Netzwechselspannung proportionaler Teil herabgesetzt dem Integrator 4 zugeführt. Am Eingang des Integrators 4 liegt ein Schalter S6, der durch eine Ablaufsteuerung 8 jeweils zusammen mit dem Schalter S5, also während der Lastzeit, geschlossen wird. Bei geschlossenem Schalter S6 wird somit eine der Lastspannung $U_L$ proportionale Spannung am Integrator V3, C2 aufintegriert und dem Referenzeingang $U_R$ des A/D-Wandlers 5 zugeführt. Am Referenzeingang liegt somit ein Spannungswert an, der dem Mittelwert der Lastspannung $U_L$ proportional ist. Nach jedem Meßzyklus schließt ein Schalter S7 den Ausgang des Integrators V3, C2 kurz, so daß dieser für einen neuen Meßzyklus zur Verfügung steht.

Die Differenzspannungs-Meßschaltung 7 erfaßt von der am Spannungsteiler R1, R2 anliegenden Wechselspannung durch einen Komparator K jeweils die Nulldurchgänge und bestimmt damit den Takt für die Ablaufsteuerung 8. In Abhängigkeit von diesem Takt steuert die Ablaufsteuerung die bereits genannten Schalter S5, S6, S7 sowie weitere zur Differenzspannungs-Meßschaltung 7 gehörige Schalter S1, S2, S3. Die Schalter S1, S2 führen eine vom Spannungsteiler R1, R2 abgegriffene Spannung einem Integrator V2, C1 zu. Dem Schalter S2 ist ein Inverter V1 vorgeschaltet, der dafür sorgt, daß die Wechselspannung gegenphasig, also um 180° gedreht, an den beiden Schaltern S1, S2 anliegt. Beide Schalter werden durch die Ablaufsteuerung so getaktet, daß dem Integrator V2, C1 abwechselnd zwei positive und dann zwei negative Halbwellen zugeführt werden. Es wird somit über je zwei Halbwellen aufintegriert und anschließend über je zwei Halbwellen abintegriert. Die am Ausgang des Integrators V2, C1 verbleibende Spannung $_\Delta U$ ist dem Mittelwert einer aus Leerlaufspannung und Lastspannung gebildeten Differenzspannung proportional.

Der A/D-Wandler 5 führt der Anzeigeeinheit 6 einen Wert zu, der dem Verhältnis der Spannung am Meßeingang $U_M$ zur Spannung am Referenzeingang $U_R$ entspricht. Bei konstanter Referenzspannung ist der ausgegebene Meßwert der Spannung am Meßeingang $U_M$ proportional. Schwankungen des Meßwertes am Meßeingang $U_M$, die im gleichen Verhältnis auch am Referenzeingang $U_R$ auftreten, werden eliminiert.

## Patentansprüche

1. Meßverfahren zur Bestimmung des Schleifen- oder Innenwiderstandes eines Wechselstromnetzes unter Anwendung eines Meßverfahrens zur Ermittlung der Differenz zwischen zwei Spannungen durch einen zeitgesteuerten Meßablauf, der dafür sorgt, daß in aufeinanderfolgenden, fest vorgegebenen Zeitspannen zuerst die eine und dann die andere Spannung integriert wird, und daß zur digitalen Anzeige des Meßwertes eine A/D-Wandlung erfolgt, dadurch gekennzeichnet, daß ein dem Mittelwert der Differenz zweier zunächst gleichgerichteter und dann integrierter, bei unterschiedlicher Last gemessener Wechselspannungen proportionaler erster Wert bei der A/D-Wandlung als Meßwert dient, und ein dem Mittelwert der Differenz zunächst gleichgerichteter und dann integrierter der Last entsprechender Lastströme proportionaler zweiter Wert bei der A/D-Wandlung als Referenzwert dient, daß ein zyklischer Wechsel zwischen den Zeiten unterschiedlicher Last erfolgt und daß durch die A/D-Wandlung das Verhältnis des ersten Wertes zum zweiten Wert gebildet wird.

2. Verfahren nach Anspruch 1, dadurch gekennzeichnet, daß die Zeiten unterschiedlicher Last eine Leerlauf- und eine Lastzeit sind und der während der Lastzeit den Laststrom bestimmende Lastwiderstand ein entsprechend genauer Meßwiderstand ist, so daß der Laststrom sich nur in Abhängigkeit von der Netzspannung ändert und eine der Netzspannung proportionale, entsprechend herabgesetzte Spannung während der Lastzeit zunächst gleichgerichtet und dann integriert als Referenzsignal für die A/D-Wandlung dient.

3. Verfahren nach einem der vorhergehenden Ansprüche, dadurch gekennzeichnet, daß einer über eine Periode laufenden Leerlaufzeit eine gleich lange Lastzeit folgt und ein Meßzyklus zur Ausgabe des ermittelten Widerstandswertes mehrere Lastzeitenwechsel erfaßt.

4. Meßverfahren nach einem der vorhergehenden Ansprüche, dadurch gekennzeichnet, daß zur Bildung der Differenzspannung bei der einen Wechselspannung mehrere Halbwellen zunächst gleichgerichtet und dann aufintegriert werden und daß bei der anderen Wechselspannung gleich viele Halbwellen zunächst gleichgerichtet und dann abintegriert werden und daß vorzugsweise jeweils beide Halbwellen einer Periode integriert werden.

5. Meßverfahren nach Anspruch 4, dadurch gekennzeichnet, daß die Abintegration im gleichen Nulldurchgang beginnt, in dem die Aufintegration endet.

6. Meßverfahren nach Anspruch 4 oder 5, dadurch gekennzeichnet, daß die Differenzspannung über mehrere, vorzugsweise drei, eine Integrationsphase bildende Integrationszyklen ermittelt wird, wobei jeder Integrationszyklus eine Auf- und eine Abintegration umfaßt und die am Integrator anstehende Summenspannung durch die Zahl der Integrationszyklen geteilt wird.

7. Meßvorrichtung zur Bestimmung des Schleifen- oder Innenwiderstandes eines Wechselstromnetzes mit einer am Netz anliegenden, aus der Reihenschaltung eines bekannten Lastwiderstandes ($R_L$) und eines Lastschalters (S5) bestehenden Lastschaltung (2) zu der der Eingang einer Differenzspannungs-Meßschaltung (7) parallelgeschaltet ist, sowie mit einem A/D-Wandler (5), dadurch gekennzeichnet, daß weiterhin ein Spannungsteiler (3) der Lastschaltung (2) parallelgeschaltet ist und der Ausgang der Differenzspannungs-Meßschaltung (7) mit dem Meßeingang ($U_M$) des A/D Wandlers (5) und der Ausgang einer mit ihrem Eingang an dem Ausgang des Spannungsteilers (3) liegenden Integrationsschaltung (4) mit dem Referenzeingang ($U_R$) des A/D-Wandlers (5) verbunden ist und daß eine den Meßablauf bestimmende Ablaufsteuerung (8) den Lastschalter (S5), die Integrationsschaltung (4), den A/D-Wandler (5) und die Differenzspannungs-Meßschaltung (7) steuert.

8. Meßvorrichtung nach Anspruch 7, dadurch gekennzeichnet, daß als A/D-Wandler ein Dual-Slope-Wandler dient, der mit einem Anzeigeteil (6) eine Baueinheit bildet.

9. Meßvorrichtung nach Anspruch 7 oder 8, dadurch gekennzeichnet, daß der Spannungsteiler (3) aus zwei Widerständen und einem Einweggleichrichter besteht und die Integrationsschaltung (4) mit ihrem Eingang über einen Schalter (S6) am Ausgang des Spannungsteilers (3) liegt und ein weiterer Schalter (S7) den Ausgang des Integrators (4) kurzschließen kann.

10. Meßvorrichtung nach einem der Ansprüche 7 bis 9, dadurch gekennzeichnet, daß die Differenzspannungs-Meßschaltung (7) über einen am Ausgang eines weiteren Spannungsteilers (R1,R2) liegenden Komparator (K) die Nulldurchgänge der Wechselspannung erfaßt und in Abhängigkeit von diesen nach einem durch die Ablaufsteuerung vorgegebenen Programm mehrere Schalter (S1 bis S3) steuert, wobei ein erster Schalter (S1) und ein dazu parallelliegender zweiter Schalter (S2) den Ausgang des weiteren Spannungsteilers (R1,R2) mit dem Eingang eines Integrators (V2,C1) verbindet und einem dieser beiden Schalter (S1,S2) ein Inverter (V1) vorgeschaltet ist und der Ausgang des Integrators (V2,C1) durch einen dritten Schalter (S3) überbrückt ist, der ein Löschen des Integratorinhalts ermöglicht.

## Claims

1. Method for determining the loop or internal impedance of an a.c. system using a method of measurement to determine the difference between two voltages by means of a time-controlled measurement sequence which ensures that firstly the one and then the other voltage is integrated in sequential, firmly prescribed time intervals, and that an A/D conversion is performed for the purpose of digital display of the measured value, characterised in that a first value, which is proportional to the mean value of the difference of two firstly rectified and then integrated a.c. voltages measured given different loads, serves as the measured value in the case of the A/D conversion, and a second value, which is proportional to the mean value of the difference of firstly rectified and then integrated load currents corresponding to the load, serves as the reference value in the case of the A/D conversion, in that there is a cyclic alternation between the times of different load, and in that the ratio of the first value to the second value is formed by the A/D conversion.

2. Method according to Claim 1, characterised in that the times of different load are an open-circuit time and a load time and the load impedance determining the load current during the load time is a correspondingly accurate precision resistor, so that the load current varies only as a function of the supply voltage and a voltage that is proportional to the supply voltage and is correspondingly reduced is firstly rectified during the load time and then integrated as reference signal for the A/D conversion.

3. Method according to one of the preceding claims, characterised in that an open-circuit time running over one period is followed by a load time of equal length, and for the purpose of outputting the determined impedance value a measurement cycle includes a plurality of load time alternations.

4. Method of measurement according to one of the preceding claims, characterised in that, for the purpose of forming the error voltage, in the case of the one a.c. voltage a plurality of half-waves are firstly rectified and then integrated upslope, and in that in the case of the other a.c. voltage the same number of half-waves are firstly rectified and then integrated downslope, and in that preferably both the half-waves of a period are integrated in each case.

5. Method of measurement according to Claim 4, characterised in that the downslope integration starts at the same zero crossing at which the upslope integration ends.

6. Method of measurement according to Claim 4 or 5, characterised in that the error voltage is determined over a plurality of, preferably three, integration cycles forming an integration phase, each integration cycle including an upslope and a downslope integration, and the sum voltage present at the integrator being divided by the number of the integration cycles.

7. Measuring device for determining the loop or internal impedance of an a.c. system, having a load circuit (2), which is connected to the system and consists of the series circuit of a known load impedance ($R_L$) and a switch (S5), and to which the input of an error voltage measuring circuit (7) is connected in parallel, and having an A/D converter (5), characterised in that, furthermore, a voltage divider (3) is connected in parallel to the load circuit (2) and the output of the error voltage measuring circuit (7) is connected to the measurement input ($U_M$) of the A/D converter (5), and the output of an integrator (4) that is connected with its input to the output of the voltage divider (3) is connected to the reference input ($U_R$) of the A/D converter (5), and in that a sequential control (8) determining the measurement sequence controls the switch (S5), the integrator (4), the A/D converter (5) and the error voltage measuring circuit (7).

8. Measuring device according to Claim 7, characterised in that a dual-slope converter that forms a unit with a display element (b) serves as the A/D converter.

9. Measuring device according to Claim 7 or 8, characterised in that the voltage divider (3) consists of two resistors and a half-wave rectifier, and the integrator (4) is connected with its input via a switch (S6) to the output of the voltage divider (3), and a further switch (S7) can short-circuit the output of the integrator (4).

10. Measuring device according to one of Claims 7 to 9, characterised in that the error voltage measuring circuit (7) measures the zero crossings of the a.c. voltage via a comparator (K) connected to the output of a further voltage divider (R1, R2) and controls a plurality of switches (S1 to S3) as a function of said zero crossings using a programme prescribed by the sequential control, a first switch (S1) and a second switch (S2) located in parallel therewith connecting the output of the further voltage divider (R1, R2) to the input of an integrator (V2, C1), and an inverter (V1) being connected upstream of one of these two switches (S1, S2), and the output of the integrator (V2, C1) being short-circuited by a third switch (S3) which facilitates erasure of the integrator contents.

**Revendications**

1. Procédé de mesure pour la détermination de la résistance de boucle ou de la résistance interne d'un réseau à courant alternatif utilisant un procédé de mesure pour la détermination de la différence entre deux tensions par un déroulement séquentiel de la mesure, qui agit de manière telle qu'à intervalles prédéterminés fixes successifs l'une puis l'autre tension est intégrée, et qu'Lne conversion A/D est opérée pour l'affichage numérique de la valeur de mesure, caractérisé en ce qu'une première valeur proportionnelle à la valeur moyenne de la différence entre deux tensions alternatives mesurées sous des charges différentes redressées puis intégrées, est utilisée comme valeur de mesure pour la conversion A/D et une deuxième valeur proportionnelle à la valeur moyenne de la différence entre des courants sous charge, correspondant à la charge, redressés et intégrés est utilisée comme valeur de référence pour la conversion A/D, en ce qu'on réalise un changement cyclique entre des périodes de charge différentes et en ce qu'on détermine le rapport de la première valeur à la deuxième valeur par la conversion A/D.

2. Procédé selon la revendication 1, caractérisé en ce que les périodes de charge différentes sont une période à vide et une période sous charge et la résistance de charge déterminant le courant sous charge pendant là période de charge est une résistance de mesure de précision adaptée, de sorte que le courant sous charge ne varie qu'en fonction de la tension du réseau et une tension abaissée correspondante proportionnelle à la tension du réseau redressée et intégrée pendant la période de charge est utilisée comme signal de référence pour la conversion A/D.

3. Procédé selon l'une des revendications précédentes, caractérisé en ce qu'une période à vide correspondant à une période est suivie d'une période de charge de même longueur et un cycle de mesure mesure plusieurs alternances de périodes de charge pour délivrer la valeur de la résistance déterminée.

4. Procédé de mesure selon l'une des revendications précédentes, caractérisé en ce que pour la détermination de la tension différentielle, plusieurs demi-ondes de l'une des tensions alternatives sont redressées et intégrées positivement et en ce qu'un nombre égal de demi-ondes de l'autre tension alternative sont redressées et intégrées négativement et en ce que de préférence chaque fois les deux demi-ondes d'une période sont intégrées.

5. Procédé de mesure selon la revendication 4, caractérisé en ce que l'intégration négative commence au passage par zéro qui correspond à la fin de l'intégration positive.

6. Procédé de mesure selon la revendication 4 ou 5, caractérisé en ce que la tension différentielle est déterminée sur plusieurs, de préférence trois cycles d'intégration formant une phase d'intégration, chaque cycle d'intégration comprenant une intégration positive et une intégration négative et la tension cumulée disponible au niveau de l'intégrateur est divisée par le nombre de cycles d'intégration.

7. Dispositif de mesure pour la détermination de la résistance de boucle ou de la résistance interne d'un réseau à courant alternatif, comprenant un circuit de charge (2) constitué par le montage en série d'une résistance de charge ($R_L$) connue et d'un commutateur de charge ($S_5$) avec lequel l'entrée d'un circuit de mesure de la tension différentielle (7) est branchée en parallèle, ainsi qu'avec un convertisseur A/D (5), caractérisé en ce qu'en outre un diviseur de tension (3) est branché en parallèle avec le circuit de charge (2) et la sortie du circuit de mesure de tension différentielle (7) est reliée à l'entrée de mesure ($U_M$) du convertisseur A/D (5) et la sortie d'un circuit d'intégration (4) dont l'entrée est connectée à la sortie du diviseur de tension (3) est reliée à l'entrée de référence ($U_R$) du convertisseur A/D et en ce qu'une commande séquentielle (8) déterminant le déroulement de la mesure commande le commutateur de charge ($S_5$), le circuit d'intégration (4), le convertisseur A/D (5) et le circuit de mesure de tension différentielle (7).

8. Dispositif de mesure selon la revendication 7, caractérisé en ce que le convertisseur A/D est un convertisseur à double boucle, qui forme une unité de construction avec la partie d'affichage (6).

9. Dispositif de mesure selon la revendication 7 ou 8, caractérisé en ce que le diviseur de tension (3) se compose de deux résistances et d' un redresseur demi-onde et le circuit d'intégration (4) est relié par son entrée, par l'intermédiaire d'un commutateur ($S_6$) à la sortie du diviseur de tension (3) et un commutateur supplémentaire ($S_7$) peut court-circuiter la sortie de l'intégrateur (4).

10. Dispositif de mesure selon l'une des revendications 7 à 9, caractérisé en ce que le circuit de mesure de tension différentielle (7) mesure les passages par zéro de la tension alternative au moyen d'un comparateur (K) branché à la sortie d'un autre diviseur de tension ($R_1$, $R_2$) et commande en fonction de ceux-ci, d'après un programme défini par la commande séquentielle, plusieurs commutateurs ($S_1$ à $S_3$), un premier commutateur ($S_1$) et un deuxième commutateur ($S_2$) monté en parallèle avec celui-ci reliant la sortie de l'autre diviseur de tension ($R_1$, $R_2$) avec l'entrée d'un intégrateur ($V_2$, $C_1$) et un inverseur ($V_1$) étant monté en amont de l'un de ces deux commutateurs ($S_1$, $S_2$) et la sortie de l'intégrateur ($v_2$, $C_1$) étant court-circuitée par un troisième commutateur ($S_3$) qui permet l'effacement du contenu de l'intégrateur.